# EUROPÄISCHE PATENTSCHRIFT

(11) **EP 0 392 056 B1**
(45) Veröffentlichungstag und Bekanntmachung des Hinweises auf die Patenterteilung: **14.12.1994**
(21) Anmeldenummer: 89106651.6
(22) Anmeldetag: 13.04.1989
(51) Int. Cl.: H04L 7/033, H03L 7/081

(54) **Taktsignalschaltung**
Circuit for a clock signal
Circuit pour signal d'horloge

(43) Veröffentlichungstag der Anmeldung: 17.10.1990
(73) Patentinhaber: SIEMENS AKTIENGESELLSCHAFT, 80333 München (DE)
(72) Erfinder: Trummp, Gerhard, Dipl.-Ing., D-8039 Puchheim (DE)

(56) Entgegenhaltungen:
- EP-A- 0 274 606
- US-A- 3 781 470
- US-A- 3 931 588
- IEEE JOURNAL OF SOLID-STATE CIRCUITS, Band SC-20, Nr. 3, Juni 1985, Seiten 770-774, IEEE, New York, US; R. WOUDSMA et al.: "The modular design of clock-generator circuits in a CMOS building-block system"
- IEEE JOURNAL OF SOLID-STATE CIRCUITS, Band SC-22, Nr. 2, April 1987, Seiten255-261, IEEE, New York, US; D.-K. JEONG et al.: "Design of PLL-based clockgeneration circuits"

## Beschreibung

In Breitband-Digitalsignal-Vermittlungs- u./o. -Übertragungssystemen ebenso wie in Datenverarbeitungsanlagen setzen Laufzeiteffekte dem zeitlichen Auflösungsvermögen des Systems und damit der maximal zulässigen Bitrate eine Grenze, die indessen durch - ggf. in kurzen räumlichen Abständen wiederholte - Zeitregeneration der Digitalsignale (Daten) nach oben verschiebbar ist. Zu einer solchen Zeitregeneration können in synchronen, d.h. mit einem einheitlichen Systemtakt mit einer der Bitrate der durchzuschaltenden Digitalsignale entsprechenden Taktfrequenz betriebenen Koppelanordnungen in die zwischen den Koppelstufen verlaufenden Zwischenleitungen und/oder in die Koppelstufen selbst systemtaktgesteuerte bistabile Kippglieder eingefügt sein, denen der Systemtakt über entsprechende Verzögerungsglieder jeweils in einer Phasenlage zugeführt wird, die der in der Koppelanordnung bis zu der betreffenden Zwischenleitung gegebenen Laufzeit durchgeschalteter Digitalsignale entspricht (DE-C2-2 836 695, Fig. 1 und 2; 1986 Intern. Zürich Seminar Conference Papers C.4.1...4); die Taktphase des Systemtakts soll dabei jeweils mit der zeitlichen Mitte eines gerade durchgeschalteten Digitalsignalelements zusammenfallen, so daß das betreffende Signalelement mit hoher Zuverlässigkeit regeneriert wird. Ganz allgemein stellt sich so mit bei entsprechend hohen Taktfequenzen das Problem, in einem Taktverteilsystem den Systemtakt mit einer im Nanosekundenbereich liegenden Phasengenauigkeit zu verteilen, wobei ein von außen an einen IC-Baustein angelegtes (externes, Referenz-)Taktsignal, das die Übernahme, Durchschaltung oder Verarbeitung von Digitalsignalelementen auf dem IC-Baustein steuert, dazu entsprechend zeittoleranzarm und mit der erforderlichen Treiberfähigkeit chipintern aufzubereiten ist.

Entsprechende chip-interne C-MOS-Treiberschaltungen, denen ggf. auch noch ein Pegelumsetzer vorgeschaltet sein kann, werden, um ohne hohe Belastung der externen Referenztaktsignalquelle auch größere Lastkapazitäten umladen zu können, in der Regel mehrstufig auszubilden und somit regelmäßig mit Verzögerungszeiten in der Größe mehrerer C-MOS-Inverterlaufzeiten verbunden sein, und wie diese ändern sich auch solche Verzögerungszeiten mit der Versorgungsspannung, mit der Umgebungstemperatur und/oder aufgrund von technologiebedingten Parameterstreuungen. Dabei werden für das Verhältnis von maximaler zu minimaler Verzögerungszeit für den ungünstigsten Fall Werte zwischen 2,5 und 4 genannt. Um wenigstens den Betrag der Streuung klein zu halten, sind möglichst kleine Verzögerungszeiten anzustreben.

Zur Ableitung eines Taktsignals aus einem Referenztaktsignal ist (aus IEEE Journal of Solid-State Circuits, VOL. SC-20, No. 3, June 1985, p.770...774) ein (2,5µ-MOS-)Taktgenerator bekannt, der eine vom Referenztaktsignal beaufschlagte Kette von C-MOS-Inverter enthaltenden Verzögerungselementen aufweist, die in ihrer Verzögerungszeit von einem an Ausgänge zweier Verzögerungselemente angeschlossenen Phasendetektor oder von dritter Seite (extern) stromquellengesteuert sind; als Verzögerungselemente sind monostabile Kippschaltungen
- mit einem RS-Flip-Flop, dessen S-Eingang den Eingang der monostabilen Kippschaltung bildet,
- mit einem nachfolgenden, an der Source-Elektrode eines seiner beiden MOS-Transistoren vom Steuereingang der steuerbaren Verzögerungskette her stromquellengesteuerten C-MOS-Inverter
- und mit einem diesem C-MOS-Inverter über einen Querkondensator nachgeschalteten Schmitt-Trigger, dessen den Ausgang der monostabilen Kippschaltung bildender Ausgang zum R-Eingang des RS-Flip-Flops rückgeführt ist,

vorgesehen. Dieser bekannte Taktgenerator ermöglicht ein geregeltes Taktverhältnis des erzeugten Taktes; eine definierte Phasenlage des erzeugtene Taktsignales in bezug auf das Referenztaktsignal ist bei diesem bekannten Taktgenerator nicht vorgesehen.

Des weiteren ist (aus IEEE Journal of Solid-State Circuits, Vol. SC-22, No.2, April 1987, p.255...261) ein (2µ-C-MOS-)PLL-Taktgenerator bekannt, der einen mit einer zu einem Ring geschlossenen Kette von Verzögerungselementen gebildeten Ringoszillator aufweist, dessen Verzögerungselemente in ihrer Verzögerungszeit von einem das erzeugte Taktsignal mit dem Referenztaktsignal vergleichenden Phasen- und Frequenzdetektor gesteuert sind; als Verzögerungselemente sind stromquellengesteuerte C-MOS-Inverter
- mit einem zwischen den MOS-Transistor des einen Kanaltyps und die zugehörige Speisepotentialquelle eingefügten, an seiner Steuerelektrode vom Steuereingang (vc) der steuerbaren Verzögerungskette her direkt angesteuerten MOS-Transistor ebenfalls des einen Kanaltyps
- und einem zwischen den MOS-Transistor des anderen Kanaltyps und die zugehörige Speisepotentialquelle eingefügten, an seiner Steuerelektrode vom Steuereingang (vc) der steuerbaren Verzögerungskette her über eine Stromspiegelschaltung angesteuerten MOS-Transistor ebenfalls des anderen Kanaltyps

vorgesehen. Dieser bekannte Taktgenerator gestattet an sich die Erzeugung eines mit dem Referenztaktsignal taktgleichen Taktsignals, wobei jedoch sowohl schnelle Änderungen des Referenztaktes als auch kurze Änderungen der Versorgungsspannung merkliche Phasenfehler zwischen erzeugtem Taktsignal und Referenztaktsignal erwarten lassen, die auf Werte größer 360° kumulieren können; ein eigentlicher Treiber ist bei dem bekannten Taktgenerator nicht vorgesehen.

Die Erfindung zeigt nun einen Weg, aus einem ggf. von außen an einen IC-Baustein angelegten Referenztaktsignal ein Takttreiberausgangssignal mit in bezug auf das Referenztaktsignal definierter Phasenlage abzuleiten.

Die Erfindung betrifft eine Taktsignalschaltung zur Bildung eines (Ausgangs-)Taktsignals mit in bezug auf ein (Eingangs-)Referenztaktsignal definierter Phasenlage, mit einer in einen Taktsignalweg eingefügten, ein oder mehrere Verzögerungselement(e) aufweisenden und von einem Phasendetektor steuerbaren Verzögerungskette; diese Taktsignalschaltung ist erfindungsgemäß dadurch gekennzeichnet, daß der steuerbaren Verzögerungskette im Taktsignalweg eine Treiberschaltung nachgeschaltet ist, wobei an den den Ausgang der Taktsignalschaltung bildenden Treiberausgang und an den den Referenztaktsignal-Eingang der Taktsignalschaltung bildenden Eingang der steuerbaren Verzögerungskette die beiden Eingänge des Phasendetektors angeschlossen sind, dessen Ausgang über ein Filter mit dem Steuereingang der steuerbaren Verzögerungskette verbunden ist.

Es sei an dieser Stelle bemerkt, daß (aus EP-A2-0 274 606) schon eien Taktsignalschaltung zur Bildung eines Ausgangstaktsignals mit in bezug auf ein Referenztaktsignal definierter Phasenlage, mit einer in einen Taktsignalweg eingefügten, mehrere Verzögerungselemente aufweisenden und von einem Phasendetektor steuerbaren Verzögerungskette bekannt ist, bei der die Laufzeit der Verzögerungselemente der Verzögerungskette in Abhängigkeit von der Phasenlage der beiden Eingangssignale des Phasendetektors beeinflußt wird, dessen einer Eingang an den Ausgang des letzten Verzögerungselements der Verzögerungskette angeschlossen und dessen anderer Eingang an einen Referenztaktsignal-Eingang angeschlossen ist. Bei dieser bekannten Taktsignalschaltung, bei der übrigens der Eingang der steuerbaren Verzögerungskette keinen Referenztaktsignal-Eingang bildet, verzweigt sich indessen der Signalweg am Ausgang des letzten Verzögerungselements einerseits zu einem Schaltungsausgang für das verzögerte Signal und andererseits zu dem einen Eingang des Phasendetektors hin, so daß bei einer etwaigen Nachschaltung einer Treiberschaltung deren Ausgangssignal nicht mehr in die Taktphasenregelung eingehen würde.

Demgegenüber bringt die Erfindung den Vorteil einer hohen zeitlichen Gleichheit des Ausgangssignals eines ohne weiteres auch mehrstufig zu realisierenden Taktsignaltreibers mit einem Referenztaktsignal, unabhängig von schaltungsinternen Verzögerungszeiten und deren versorgungsspannungs-, temperatur- u./o. parameterstreuungsbedingten Änderungen, mit sich.

Weitere Besonderheiten der Erfindung werden aus der nachfolgenden näheren Erläuterung der Erfindung anhand der Zeichnung ersichtlich. Dabei zeigt
FIG 1 das Schema einer Taktsignalschaltung gemäß der Erfindung;
FIG 2, FIG 3, FIG 4 und FIG 5 zeigen Beispiele der schaltungstechnischen Realisierung von Schaltungsbestandteilen.

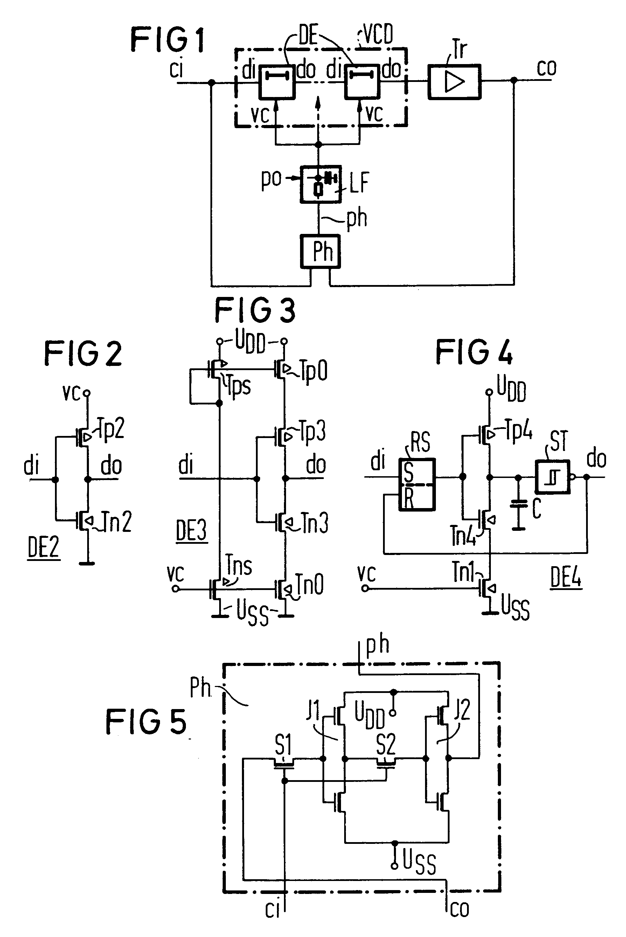

In der Zeichnung FIG 1 ist schematisch in einem zum Verständnis der Erfindung erforderlichen Umfange eine Taktsignalschaltung gemäß der Erfindung skizziert, in der in einem Taktsignalweg ci - co eine ein oder mehrere Verzögerungselement(e) DE aufweisende Verzögerungskette VCD eingefügt ist, die von einem Phasendetektor Ph gesteuert wird. Am Eingang ci des Taktsignalweges ci - co wird ein Referenztaktsignal als Eingangstaktsignal zugeführt; am Ausgang co des Taktsignalwegs ci - co tritt das in der Taktsignalschaltung gemäß FIG 1 von einer der steuerbaren Verzögerungskette VCD im Taktsignalweg ci - co nachgeschalteten Treiberschaltung Tr erzeugte Ausgangs-Taktsignal mit in Bezug auf das (Eingangs-)Referenztaktsignal definierter Phasenlage auf. Diese definierte Phasenlage, d.h. die Gleichtaktigkeit von erzeugtem (Ausgangs-)Taktsignal und (Eingangs-)Referenztaktsignal, wird durch entsprechende Regelung der Verzögerungszeit der steuerbaren Verzögerungskette VCD nach Maßgabe einer an den Steuereingängen vc ihrer Verzögerungselemente DE auftretenden Steuerspannung erreicht; hierzu ist der Ausgang des Phasendetektors Ph, dessen beiden Eingänge an den den Ausgang co der Taktsignalschaltung bildenden Treiberausgang und an den den Referenztaktsignal-Eingang ci der Taktsignalschaltung gemäß FIG 1 bildenden Eingang der steuerbaren Verzögerungskette VCD angeschlossen sind, über ein Tiefpaß-Schleifenfilter LF mit den Steuereingängen vc der Verzögerungselemente DE verbunden. Die Verzögerungselemente DE können dabei beispielsweise in einer aus FIG 2, FIG 3 oder FIG 4 ersichtlichen Weise realisiert sein.

Gemäß FIG 2 ist als Verzögerungselement (DE2) ein C-MOS-Inverter Tp2, Tn2 vorgesehen, der an den Source-Elektroden seiner beiden MOS-Transistoren Tp2, Tn2 vom Steuereingang vc her spannungsgesteuert ist.
Die mit solchen Verzögerungselementen DE2 gebildete Verzögerungskette VCD (in FIG 1) ändert ihre Verzögerungszeit in Abhängigkeit von der an den Steuereingängen vc anliegenden Steuerspannung: Bei größerer Steuerspannung und damit größerer Inverter-Betriebsspannung fließt bei einem Signalzustandswechsel des am Eingang di des Verzögerungselements DE2 auftretenden Taktsignals im dabei leitend werdenden Inverter-Transistor Tp2 bzw. Tn2 ein größerer Strom, durch den am Ausgang do des Verzögerungselements DE2 wirksame, durch diesen Strom umzuladende Schaltkapazitäten (Leitungskapazität, Eingangskapazität einer nachfolgenden Schaltungsstufe) schneller umgeladen werden, so daß die Verzögerungszeit, nach der am Schaltungsausgang do der neue Taktsignalzustand ausgebildet ist, entsprechend kleiner ist; umgekehrt ist bei kleinerer Steuerspannung die Verzögerungszeit größer.

Gemäß FIG 3 ist als Verzögerungselement (DE3) ein stromgesteuerter C-MOS-Inverter Tp3, Tn3
- mit einem zwischen den MOS-Transistor Tn3 des einen Kanaltyps und die zugehörige Speisepotentialquelle U_{SS} eingefügten, an seiner Steuerelektrode vom Steuereingang vc der steuerbaren Verzögerungskette VCD her direkt angesteuerten MOS-Transistor Tn0 ebenfalls des einen Kanaltyps
- und einem zwischen den MOS-Transistor Tp3 des anderen Kanaltyps und die zugehörige Speisepotentialquelle U_{DD} eingefügten, an seiner Steuerelektrode vom Steuereingang vc der steuerbaren Verzögerungskette VCD her über eine Stromspiegelschaltung Tns, Tps angesteuerten MOS-Transistor Tp0 ebenfalls des anderen Kanaltyps vorgesehen.
   In einem solchen Verzögerungselement DE3 wird durch die am Steuereingang vc anliegende Steuerspannung die Stromergiebigkeit des Transistors Tn0 und über die Stromspiegel-Schaltung Tns, Tps auch diejenige des Transistors Tp0 gesteuert; dieser Strom gelangt über die vom Eingang di des Verzögerungselements DE3 her mit dem zu verzögernden Taktsignal angesteuerten Inverter-Transistoren Tn3, Tp3 im Rhythmus des Taktsignals zu dem mit der Leitungskapazität und mit der Eingangskapazität einer nachfolgenden Schaltungsstufe kapazitiv belasteten Ausgang do des Verzögerungselements DE3, so daß es am Ausgang do zu einem entsprechenden Umladungsvorgang kommt: Ist die am Steuereingang vc auftretende Steuerspannung groß, so ist auch der jeweilige Umladestrom groß, und die Verzögerungszeit ist entsprechend klein; umgekehrt ist bei kleiner Steuerspannung und damit kleinem Umladestrom die Verzögerungszeit entsprechend groß.
   Verzögerungselemente, wie sie in FIG 3 skizziert sind, sind an sich (aus IEEE Journal of Solid-State Circuits, Vol. SC-22, No.2, April 1987, p.255...261, Fig.3) bereits bekannt.

An sich (aus IEEE Journal of Solid-State Circuits, VOL. SC-20, No. 3, June 1985, p.770...774, Fig. 4) bekannt ist auch das in FIG 4 skizzierte Verzögerungselement DE4. Gemäß FIG 4 ist als Verzögerungselement (DE4) eine monostabile Kippschaltung
- mit einem RS-Flip-Flop RS, dessen S-Eingang den Eingang der monostabilen Kippschaltung bildet,
- mit einem nachfolgenden, an der Source-Elektrode eines seiner beiden MOS-Transistoren Tp4, Tn4 vom Steuereingang vc der steuerbaren Verzögerungskette (VCD) her stromquellengesteuerten C-MOS-Inverter Tp4, Tn4
- und mit einem diesem C-MOS-Inverter Tp4, Tn4 über eine Querkapazität C nachgeschalteten Schmitt-Trigger ST, dessen den Ausgang der monostabilen Kippschaltung bildender Ausgang zum R-Eingang des RS-Flip-Flops RS rückgeführt ist,
   vorgesehen.
   Ein am Eingang di des Verzögerungselements DE4 auftretender LOW-Signalzustand wird vom RS-Flip-Flop RS übernommen, so daß der p-Kanal-Transistor Tp4 des C-MOS-Inverters Tp4, Tn4 leitend wird und die nachfolgende Querkapazität C, die ggf. zumindest teilweise durch Leitungskapazitäten u./o. die Eingangskapazität des nachfolgenden Schmitt-Triggers gebildet sein kann, mit dem U_{DD}-Potential aufgeladen wird. Nach Erreichen der Schaltschwelle des invertierenden Schmitt-Triggers ST herrscht an dessen Ausgang und damit auch am R-Eingang des RS-Flip-Flops RS der LOW-Zustand; dieser Schaltungszustand besteht so lange, wie am Schaltungseingang di der LOW-Zustand gegeben ist. Wenn es im am Schaltungseingang di auftretenden Taktsignal zu einem Zustandswechsel in den HIGH-signalzustand kommt, wird das RS-Flip-Flop RS gesetzt mit der Folge, daß der p-Kanal-Transistor Tp4 gesperrt und der n-Kanal-Transistor Tn4 leitend gemacht wird, so daß die Kapazität C auf das U_{SS}-Potential hin umgeladen wird, bis die Schaltschwelle des invertierenden Schmitt-Triggers ST unterschritten wird und dieser an seinem Ausgang ein HIGH-Signal abgibt, durch das zugleich das RS-Flip-Flop rückgesetzt wird.
   Die Umladezeit und damit die Verzögerungszeit vom Auftreten des HIGH-Signalzustands am Schaltungseingang di bis zum Auftreten des HIGH-Signalzustands am Schaltungsausgang do wird dabei durch den mittels des n-Kanal-Transistors Tn1 eingeprägten Umladestrom bestimmt: Bei größerer am Steuereingang vc auftretender Steuerspannung ist der Umladestrom größer und ist damit die Verzögerungszeit kleiner; umgekehrt ist bei kleinerer Steuerspannung der Umladestrom kleiner und damit die Verzögerungszeit größer.

Um nun wieder auf FIG 1 zurückzukommen, so wird das in der Verzögerungskette VCD verzögerte Taktsignal in der - ohne weiteres auch mehrstufig zu realisierenden - Treiberschaltung TR so verstärkt, daß bei dem am Treiberausgang und damit am Ausgang co der Taktsignalschaltung auftretenden Taktsignal die erforderliche Flankenübergangszeit (Steilheit) erreicht wird; das am Treiberausgang co auftretende (Ausgangs-)Taktsignal und das am Schaltungseingang ci auftretende (Eingangs-)Referenztaktsignal werden im Phasendetektor Ph miteinander verglichen.

Als Phasendetektor kann dazu vorzugsweise ein dynamisches D-Flip-Flop verwendet werden, wie es in FIG 5 skizziert ist. Gemäß FIG 5 weist der Phasendetektor Ph zwei in Kette geschaltete Stufen je eines C-MOS-Inverters J1 bzw. J2 und eines vorgeschalteten Transistorschalters S1 bzw. S2 auf, der zusammen mit der Eingangskapazität des jeweiligen Inverters J1 bzw. J2 eine Sample-and-Hold-Schaltung bildet. Eingangsseitig ist die - den D-Eingang des D-Flip-Flops bildende - der Kettenschaltung abgewandte Hauptelektrode des ersten Transistorschalters S1 mit dem Taktsignalausgang co (in FIG 1) der Taktsignalschaltung verbunden und sind die - den C-Eingang des D-Flip-Flops bildenden - Steuerelektroden beider Transistorschalter S1 und S2 mit dem Referenztaktsignaleingang ci (in FIG 1) der Taktsignalschaltung verbunden; der den Ausgang ph des Phasendetektors Ph gemäß FIG 5 bildende Ausgang des zweiten Inverters J2 führt über das Schleifenfilter (LF in FIG 1), welches das Phasendetektor-Ausgangssignal mittels einer (vorzugsweise RC-)Tiefpaßschaltung integriert, zu den Steuereingängen vc (in FIG 1) der Verzögerungselemente DE (in FIG 1). Dabei kann, wie dies auch in FIG 1 angedeutet ist, am Schliefenfilter LF über einen zusätzlichen Eingang po durch ein entsprechendes Gleichstromsignal eine Anfangsbedingung vorgegeben werden, die verhindert, daß die Taktsignalschaltung versucht, sich auf unerwünschte Verzögerungszeiten (z.B. drei Taktperioden) oder auf nichterreichbare Verzögerungszeiten (z.B. 0 oder 10 Taktperioden) einzuregeln. Zweckmäßigerweise wird die Taktsignalschaltung eine Verzögerung von einer Taktperiode zwischen dem an ihrem Eingang ci auftretenden Referenztaktsignal und dem an ihrem Ausgang co auftretenden Ausgangs-Taktsignal ausregeln, doch sind auch andere Vielfache von halben Taktperioden möglich.

Wird in den vom Ausgang co zum Phasendetektor Ph führenden Rückkopplungsweig ein verzögerndes Schaltelement eingefügt, so kann das von der Treiberschaltung Tr am Schaltungsausgang co abgegebene Taktsignal in seiner Phasenlage auch dem am Schaltungseingang ci auftretenden Referenztaktsignal vorauseilen. Auf diese Weise läßt sich ggf. auch eine zusätzliche Signalverzögerung kompensieren, die durch einen Pegelumsetzer verursacht wird, der ggf. dem Eingang ci der Taktsignalschaltung noch vorgeschaltet sein kann, um erforderlichenfalls einen gegebenen externen Taktsignalpegel auf den erforderlichen Referenztaktsignalpegel umzusetzen. Dies braucht hier jedoch nicht weiter erläutert zu werden, da dies zum Verständnis der Erfindung nicht mehr erforderlich ist.

Anschließend sei noch bemerkt, daß die vorstehend beschriebene Erfindung nicht auf in C-MOS-Technik gehaltene Schaltungen beschränkt ist, vielmehr auch bei Einsatz anderer IC-Technologien Anwendung finden kann.

## Patentansprüche

1. Taktsignalschaltung zur Bildung eines (Ausgangs-)Taktsignals mit in Bezug auf ein (Eingangs-)Referenztaktsignal definierter Phasenlage, mit einer in einen Taktsignalweg (ci - co) eingefügten, ein oder mehrere Verzögerungselement(e) (DE) aufweisenden und von einem Phasendetektor (Ph) steuerbaren Verzögerungskette (VCD), wobei die Laufzeit der (des) Verzögerungselemente(s) (DE) der Verzögerungskette in Abhängigkeit von der Phasenlage der beiden Eingangssignale des Phasendetektors (Ph) beeinflusst wird, dessen einer Eingang mit dem Ausgang (do) des letzten Verzögerungselementes (DE) der Verzögerungskette (VCD) verbunden ist und dessen anderer Eingang an einen Referenztaktsignal-Eingang (ci) angeschlossen ist,
**dadurch gekennzeichnet,**
daß im Taktsignalweg (ci - co) der steuerbaren Verzögerungskette (VCD) eine Treiberschaltung (Tr) nachgeschaltet ist, wobei an den den Ausgang (co) der Taktsignalschaltung bildenden Treiberausgang und an den den Referenztaktsignal-Eingang (ci) der Taktsignalschaltung bildenden Eingang der steuerbaren Verzögerungskette (VCD) die beiden Eingänge des Phasendetektors (Ph) angeschlossen sind, dessen Ausgang über ein Filter (LF) mit dem Steuereingang (vc) der steuerbaren Verzögerungskette (VCD) verbunden ist.

2. Taktsignalschaltung nach Anspruch 1,
**dadurch gekennzeichnet,**
daß als Verzögerungselement (DE2) ein an den Source-Elektroden seiner beiden MOS-Transistoren (Tp2, Tn2) vom Steuereingang (vc) der steuerbaren Verzögerungskette (VCD) her spannungsgesteuerter C-MOS-Inverter (Tp2, Tn2) vorgesehen ist.

3. Taktsignalschaltung nach Anspruch 1,
**dadurch gekennzeichnet,**
daß als Verzögerungselement (DE3) ein stromgesteuerter C-MOS-Inverter (Tp3, Tn3)
- mit einem zwischen den MOS-Transistor (Tn3) des einen Kanaltyps und die zugehörige Speisepotentialquelle (U_{SS}) eingefügten, an seiner Steuerelektrode vom Steuereingang (vc) der steuerbaren Verzögerungskette (VCD) her direkt angesteuerten MOS-Transistor (Tn0) ebenfalls des einen Kanaltyps
- und einem zwischen den MOS-Transistor (Tp3) des anderen Kanaltyps und die zugehörige Speisepotentialquelle (U_{DD}) eingefügten, an seiner Steuerelektrode vom Steuereingang (vc) der steuerbaren Verzögerungskette (VCD) her über eine Stromspiegelschaltung (Tns, Tps) angesteuerten MOS-Transistor (Tp0) ebenfalls des anderen Kanaltyps
vorgesehen ist.

4. Taktsignalschaltung nach Anspruch 1,
**dadurch gekennzeichnet,**
daß als Verzögerungselement (DE4) eine monostabile Kippschaltung
- mit einem RS-Flip-Flop (RS), dessen S-Eingang den Eingang der monostabilen Kippschaltung bildet,
- mit einem nachfolgenden, an der Source-Elektrode eines seiner beiden MOS-Transistoren (Tp4, Tn4) vom Steuereingang (vc) der steuerbaren Verzögerungskette (VCD) her stromquellengesteuerten C-MOS-Inverter (Tp4, Tn4)
- und mit einem diesem C-MOS-Inverter (Tp4, Tn4) über eine Lastkapazität (C) nachgeschalteten Schmitt-Trigger (ST) dessen den Ausgang der monostabilen Kippschaltung bildender Ausgang zum R-Eingang des RS-Flip-Flops (RS) rückgeführt ist, vorgesehen ist.

5. Taktsignalschaltung nach einem der Ansprüche 1 bis 4,
**dadurch gekennzeichnet,**
daß als Phasendetektor (Ph) ein mit zwei in Kette geschalteten Stufen (S1-J1; S2-J2) je eines Inverters (J1; J2) und eines vorgeschalteten FET-Schalters (S1; S2) gebildetes dynamisches D-Flip-Flop vorgesehen ist.

## Claims

1. Clock signal circuit for forming an (output) clock signal having a phase angle defined with reference to an (input) reference clock signal, with a delay chain (VCD) which is inserted into a clock signal path (ci - co), has one or more delay element(s) (DE) and can be controlled by a phase detector (Ph), the transit time of the delay element(s) (DE) of the delay chain being influenced in dependence on the phase angle of the two input signals of the phase detector (Ph), one input of which is connected to the output (do) of the last delay element (DE) of the delay chain (VCD) and the other input of which is connected to a reference clock signal input (ci), characterized in that a driver circuit (Tr) is connected downstream in the clock signal path (ci - co) of the controllable delay chain (VCD), the two inputs of the phase detector (Ph) being connected to the driver output, forming the output (co) of the clock signal circuit, and to the input, forming the reference clock signal input (ci) of the clock signal circuit, of the controllable delay chain (VCD), the output of which phase detector is connected to the control input (vc) of the controllable delay chain (VCD) via a filter (LF).

2. Clock signal circuit according to Claim 1, characterized in that, as delay element (DE2), a CMOS inverter (Tp2, Tn2) is provided which is voltage-controlled at the source electrodes of its two MOS transistors (Tp2, Tn2) from the control input (vc) of the controllable delay chain (VCD).

3. Clock signal circuit according to Claim 1, characterized in that, as delay element (DE3), a current-controlled CMOS inverter (Tp3, Tn3) is provided which is provided
- with an MOS transistor (Tn0) of one channel type which is inserted between the MOS transistor (Tn3), also of the one channel type, and the associated feed potential source (U_{SS}) and is driven directly at its control electrode by the control input (vc) of the controllable delay chain (VCD),
- and with an MOS transistor (Tp0) of the other channel type, which is inserted between the MOS transistor (Tp3), also of the other channel type, and the associated feed potential source (U_{DD}) and is driven at its control electrode from the control input (vc) of the controllable delay chain (VCD) via a current balancing circuit (Tns, Tps).

4. Clock signal circuit according to Claim 1, characterized in that, as delay element (DE4), a monostable multivibrator is provided, which has
- an RS flip-flop (RS), the S input of which forms the input of the monostable multivibrator,
- a downstream-connected CMOS inverter (Tp4, Tn4), which is current-source-controlled at the source electrode of one of its two MOS transistors (Tp4, Tn4) from the control input (vc) of the controllable delay chain (VCD),
- and a Schmitt trigger (ST) which is connected downstream of this CMOS inverter (Tp4, Tn4) via a load capacitor (C) and the output of which, which forms the output of the monostable multivibrator, is fed back to the R input of the RS flip-flop (RS).

5. Clock signal circuit according to one of Claims 1 to 4, characterized in that, as phase detector (Ph), a dynamic D-type flip-flop is provided which is formed with two cascaded stages (S1-J1; S2-J2) of in each case an inverter (J1; J2) and an upstream-connected FET switch (S1; S2).

## Revendications

1. Circuit de formation d'un signal de cadence (de sortie) ayant une relation de phase définie par rapport à un signal de cadence de référence (d'entrée), comportant une ligne à retard (VCD), qui est insérée dans une voie (ci - co) de transmission de signal de cadence, qui comporte un ou plusieurs éléments de retardement (DE) et qui peut être commandée par un détecteur de phase (Ph), le retard du ou des éléments de retardement (DE) de la ligne à retard étant influencé en fonction de la relation de phase des deux signaux d'entrée du détecteur de phase (Ph), dont une entrée est reliée à la sortie (do) du dernier élément de retardement (DE) de la ligne à retard (VCD) et dont l'autre entrée est raccordée à une entrée (ci) de signal de cadence de référence,
caractérisé par le fait que dans la voie (ci - co) de transmission de signal de cadence, un circuit d'attaque (Tr) est branché en aval de la ligne à retard commandable (VCD), et à la sortie du circuit d'attaque, qui constitue la sortie (co) du circuit de formation de signal de cadence, et à l'entrée, qui constitue l'entrée (ci) de signal de cadence de référence du circuit de formation de signal de cadence, de la ligne à retard (VCD) sont raccordées les deux entrées du détecteur de phase (Ph), dont la sortie est reliée par l'intermédiaire d'un filtre (LF) à l'entrée de commande (vc) de la ligne à retard commandable (VCD).

2. Circuit de formation d'un signal de cadence suivant la revendication 1, caractérisé par le fait qu'il est prévu, comme élément de retardement (DE2), un inverseur C-MOS (Tp2, Tn2) commandé par la tension aux bornes des électrodes de source de ses deux transistors MOS (Tp2, Tn2), à partir de l'entrée de commande (vc) de la ligne à retard commandable (VCD).

3. Circuit de formation d'un signal de cadence suivant la revendication 1, caractérisé par le fait qu'il est prévu comme élément de retardement (DE3), un inverseur C-MOS (Tp3, Tn3) commandé en courant et comportant
- un transistor MOS (Tn0), qui a un type de canal, qui est inséré entre le transistor MOS (Tn3) ayant le même type de canal et la source associée de potentiel d'alimentation (U_{SS}) et qui est commandé directement, sur son électrode de commande, à partir de l'entrée de commande (vc) de la ligne à retard commandable (VCD) et
- un transistor MOS (Tp0), qui a l'autre type de canal, qui est inséré entre le transistor MOS (Tp3) ayant cet autre type de canal et la source associée de potentiel d'alimentation (U_{DD}) et qui est commandé, sur son électrode de commande, à partir de l'entrée de commande (vc) de la ligne à retard commandable (VCD) par l'intermédiaire d'un circuit miroir de courant (Tns, Tps).

4. Circuit de formation d'un signal de cadence suivant la revendication 1, caractérisé par le fait
qu'il est prévu comme élément de retardement (DE4) un circuit à bascule monostable
- comportant une bascule bistable de type RS (RS), dont l'entrée S forme l'entrée du circuit à bascule monostable,
- un inverseur C-MOS (Tp4, Tn4), disposé en aval et commandé par source de courant, sur l'électrode de source de l'un de ses deux transistors MOS (Tp4, Tn4), à partir de l'entrée de commande (vc) de la ligne à retard commandable (VCD), et
- un Trigger de Schmitt (ST), qui est branché en aval de cet inverseur C-MOS (Tp4, Tn4) par l'intermédiaire d'une capacité de charge (C) et dont la sortie, qui constitue la sortie du circuit à bascule monostable, est renvoyée à l'entrée R de la bascule bistable de type RS (RS).

5. Circuit de formation d'un signal de cadence suivant l'une des revendications 1 à 4, caractérisé par le fait qu'il est prévu comme détecteur de phase (Ph) une bascule bistable de type D dynamique, formée par deux étages (S1-J1; S2-J2) branchés en cascade, formés chacun d'un inverseur (J1; J2) et d'un interrupteur FET (S1;S2) branché en amont de cet inverseur.
